# EUROPEAN PATENT SPECIFICATION

(11) **EP 4 589 721 B1**
(45) Date of publication and mention of the grant of the patent: **11.11.2026**
(21) Application number: 23907276.2
(22) Date of filing: 16.08.2023
(51) Int. Cl.: H01M 10/42, H01M 10/48, H01M 50/583, H01M 50/20, G01M 3/40, H01M 50/204, G01M 3/16

(54) **BATTERY PACK, BATTERY DEVICE, AND ELECTROLYTE LEAKAGE DETECTION METHOD**
BATTERIEPACK, BATTERIEVORRICHTUNG UND ELEKTROLYTLECKDETEKTIONSVERFAHREN
BLOC-BATTERIE, DISPOSITIF DE BATTERIE ET PROCÉDÉ DE DÉTECTION DE FUITE D'ÉLECTROLYTE

(30) Priority: 23.12.2022 KR 20220183570
(43) Date of publication of application: 23.07.2025
(73) Proprietor: LG Energy Solution, Ltd., Seoul 07335 (KR)
(72) Inventor: KIM, Dong Hyeon, Daejeon 34122 (KR)
(74) Representative: Plasseraud IP
(86) International application number: PCT/KR2023/012071
(87) International publication number: WO 2024/135986

(56) References cited:
- EP-A1- 4 109 119
- EP-A2- 1 083 619
- JP-A- 2002 251 985
- KR-A- 20100 106 136
- KR-A- 20110 075 550
- KR-A- 20190 072 272
- KR-A- 20220 109 745
- US-A- 5 824 883

## Description

### [Technical Field]

### CROSS-REFERENCE TO RELATED APPLICATION

This application claims priority to and the benefit of Korean Patent Application No. 10-2022-0183570 filed in the Korean Intellectual Property Office on December 23, 2022.

The present disclosure relates to a battery pack, a battery device, and an electrolyte solution leakage detection method.

### [Background Art]

Electric vehicles and hybrid vehicles are vehicles obtaining power by mainly using batteries as power sources for driving motors, and are alternatives capable of solving pollution and energy problems of internal combustion vehicles. For this reason, research has been actively carried out on them. Further, rechargeable batteries have been used in various other external apparatuses, as well as in vehicles.

Batteries are provided in the form of a battery pack including battery modules, in each of which a plurality of battery cells is connected. The lower cases of battery packs have structures to be connected to external devices, for example, the chassis of vehicles. In this case, if an electrolyte solution leaks from a battery cell of a battery pack, the leaked electrolyte solution may create a path between the battery cell and the lower case of the battery pack, which may break down the insulation. This insulation breakdown may result in a fire in the battery pack or damage to components using low voltages in the vehicle. For this reason, it is required to detect leakage of an electrolyte solution in a battery pack.

Examples of background art can be found in documents EP 4 109 119 A1 and EP 1 083 619 A2. In particular, the former discloses battery leakage detection, where a voltage signal of the leakage sensor is compared to a threshold voltage at the level of the battery monitoring circuit.

### [Disclosure]

### [Technical Problem]

The present disclosure attempts to provide a battery pack, a battery device, and an electrolyte solution leakage detection method capable of detecting leakage of an electrolyte solution in a battery pack.

### [Technical Solution]

A battery pack according to an exemplary embodiment is defined in the appended claims.

A battery device according to an exemplary embodiment is also provided.

An electrolyte solution leakage detection method according to an exemplary embodiment is also provided.

### [Advantageous Effects]

According to the exemplary embodiments, since electrolyte solution leakage detection is noise-robust, it is possible to prevent the electrolyte solution leakage detection sensor from being short-circuited while preventing malfunctions, and it is possible to protect the battery module, the electrolyte solution leakage detection sensor, and the battery monitoring circuit by limiting current.

### [Description of the Drawings]

FIG. 1 is a drawing illustrating a battery device according to an exemplary embodiment.
FIGS. 2 and 3 are drawings illustrating an electrolyte solution leakage detection device according to an exemplary embodiment. The example in fig. 2 does not fall under the claimed scope.
FIGS. 4 and 5 are drawings illustrating the operation of the electrolyte solution leakage detection device according to the exemplary embodiment.
FIG. 6 is a drawing illustrating an electrolyte solution leakage detection device according to an exemplary embodiment.
FIG. 7 is a flow chart illustrating an electrolyte solution leakage detection method of the battery device according to the exemplary embodiment.
FIG. 8 is a drawing illustrating an example of the structure of a battery pack according to an exemplary embodiment.

### [Mode for Invention]

In the following detailed description, only certain exemplary embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. Like reference numerals designate like elements throughout the specification.

It should be understood that when a constituent element is referred to as being "connected" to another constituent element, it may be directly connected to the other constituent element, or other constituent elements may be present between them. In contrast, it should be understood that when a constituent element is referred to as being "directly connected" to another constituent element, there is no other constituent element between them.

In the following description, expressions written in the singular forms can be comprehended as the singular forms or plural forms unless clear expressions such as "a", "an", or "single" are used.

In the flow charts described with reference to the drawings, the order of operations may be changed, and several operations may be combined, and an operation may be divided, and some operations may not be performed.

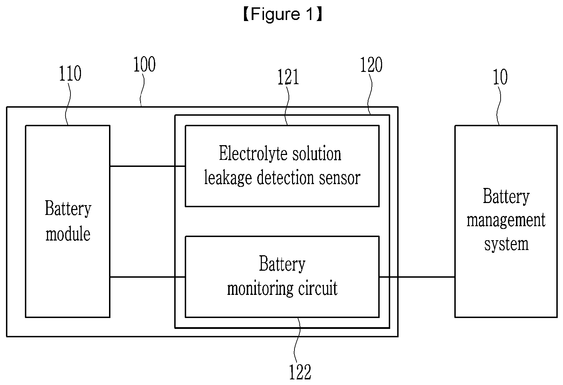

FIG. 1 is a drawing illustrating a battery device according to an exemplary embodiment.

Referring to FIG. 1, a battery device may include a battery pack 100 and a battery management system 10. The battery pack 100 includes a battery module 110 and an electrolyte solution leakage detection circuit 120.

The battery module 110 includes a plurality of battery cells (not shown in the drawings). In the exemplary embodiment, the battery cells may be rechargeable batteries, and these battery cells may include anodes, cathodes, and an electrolyte solution. In the exemplary embodiment, a predetermined number of battery cells may be connected in series or in parallel to constitute the battery module. In FIG. 1, one battery module 110 is shown for ease of explanation; however, the battery pack 100 may include one or more battery modules 110 to provide desired power.

The electrolyte solution leakage detection circuit 120 includes an electrolyte solution leakage detection sensor 121 and a battery monitoring circuit 122.

The electrolyte solution leakage detection sensor 121 is connected to the battery module 110, and may detect leakage of the electrolyte solution from the battery cells included in the battery module 110 and transmit a signal to the battery monitoring circuit 122 when detecting leakage of the electrolyte solution.

The battery monitoring circuit 122 may be connected to the battery module 110 and monitor the voltages of the battery cells. In the exemplary embodiment, the battery monitoring circuit 122 may also measure the temperature of the battery module 110. In the exemplary embodiment, the battery monitoring circuit 122 may be provided in the form of an integrated circuit (IC). When the battery monitoring circuit 122 receives the signal from the electrolyte solution leakage detection sensor 121, it may transmit the corresponding information to an external device (for example, a vehicle).

The battery monitoring circuit 122 may perform communication with the battery management system 10 of the battery device. The battery management system 10 may control the operation of the battery pack 100 by collecting data (information) which are transmitted from the battery monitoring circuit 122. Also, the battery management system 10 may transmit the information collected from the battery monitoring circuit 122 to the external device (for example, the vehicle).

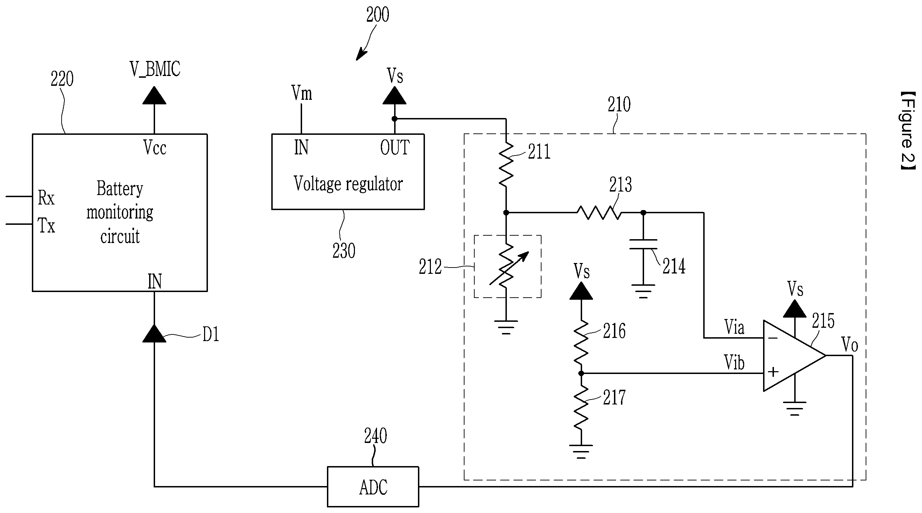

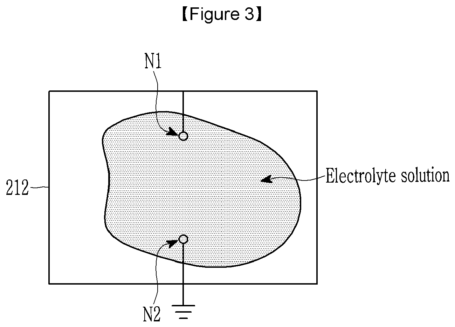

FIGS. 2 and 3 are drawings illustrating an electrolyte solution leakage detection device according to an exemplary embodiment.

Referring to FIG. 2, an electrolyte solution leakage detection device 200 (not falling within the claimed scope) may include an electrolyte solution leakage detection sensor 210 and a battery monitoring circuit 220. In the exemplary embodiment, the electrolyte solution leakage detection device 200 may correspond to the electrolyte solution leakage detection circuit 120 of FIG. 1.

In the exemplary embodiment, a power source for supplying a predetermined voltage Vs may be generated from the voltage of a battery module (for example, reference symbol "110" in FIG. 1). To this end, the electrolyte solution leakage detection device 200 may further include a voltage regulator 230. The voltage regulator 230 may receive the voltage Vm of the battery module 110 through an input terminal IN and output the predetermined voltage Vs through an output terminal OUT. The voltage Vs may be, for example, 5 V.

The electrolyte solution leakage detection sensor 210 may include a resistor 211 and an electrolyte solution detection unit 212 which are connected in series between the power source for supplying the predetermined voltage Vs and a ground terminal. The voltage of the contact point of the resistor 211 and the electrolyte solution detection unit 212 may be transferred as a detection voltage to RC filter circuits 213 and 214. The detection voltage may pass through the RC filter circuits 213 and 214 and then be input as a first input voltage Via to a comparison circuit 215. Here, the comparison circuit 215 may be an operational amplifier, and the first input voltage Via may be a voltage which is applied to the negative input terminal of the operational amplifier. Meanwhile, the electrolyte solution leakage detection sensor 210 may further include a plurality of resistors 216 and 217 which is connected in series between the power source for supplying the predetermined voltage Vs and the ground terminal. The voltage of the contact point of the plurality of resistors 216 and 217 may be input as a second input voltage Vib to the comparison circuit 215. Here, the second input voltage Vib may be a voltage which is applied to the positive input terminal of the operational amplifier.

The second input voltage Vib may be a fixed voltage for making the operational amplifier operate as a voltage comparator. For example, the plurality of resistors 216 and 217 may be set to the same resistance value as each other, and the second input voltage Vib may be set to half the value of the voltage Vs. Accordingly, when the first input voltage Via that is applied to the negative input terminal of the operational amplifier has a value larger than the second input voltage Vib, the output voltage Vo of the operational amplifier may have a value corresponding to a low level. On the other hand, when the first input voltage Via that is applied to the negative input terminal of the operational amplifier has a value smaller than the second input voltage Vib, the output voltage Vo of the operational amplifier may have a value corresponding to a high level.

In the exemplary embodiment, when the voltage Vs is set to 5 V, the resistors 211, 213, 216, and 217 may be set to 170 kΩ, 10 kΩ, 43 kΩ, and 43 kΩ, respectively, and a capacitor 214 with 47 µF may be used.

The electrolyte solution detection unit 212 may not form any current path when the electrolyte solution does not leak from the battery cells, and may form a current path by the leaked electrolyte solution when the electrolyte solution leaks from the battery cells. Referring to FIG. 3 together, the electrolyte solution detection unit 212 may include two electrolyte solution detection nodes N1 and N2 formed apart from each other. When the electrolyte solution leaks from the battery cells, the first detection node N1 and the second detection node N2 may be electrically connected.

As shown in FIG. 3, when the electrolyte solution is positioned between the first detection node N1 and the second detection node N2, since the electrolyte solution acts as a resistor having a value similar to that of the resistor 211, when the resistor 211 has been set to 170 kΩ, the same effect as if a resistor with 170 kΩ is connected in series between the voltage Vs and the ground terminal may be caused. Accordingly, the detection voltage of the contact point of the resistor 211 and the electrolyte solution detection unit 212 may drop to a voltage value corresponding to half of the voltage Vs (2.5 V when the voltage Vs is 5 V), which may be applied as the first input voltage Via to the comparison circuit 215. At this time, the second input voltage Vib of the comparison circuit 215 may be the voltage value corresponding to half of the voltage Vs (2.5 V when the voltage Vs is 5 V). By the way, the resistance value of the electrolyte solution gradually decreases over time, although initially 170 kΩ. Accordingly, the second input voltage Vib becomes lower than the voltage value corresponding to half of the voltage Vs. As a result, the first input voltage Via which is applied to the negative input terminal has a value smaller than the second input voltage Vib which is applied to the positive input terminal. In this case, the output voltage Vo of the comparison circuit 215 may become a high level (for example, 5 V).

In contrast, when the electrolyte solution does not leak from the battery cells, since the first detection node N1 and the second detection node N2 are not electrically connected, the detection voltage of the contact point of the resistor 211 and the electrolyte solution detection unit 212 may become a voltage value corresponding to the voltage Vs (5 V when the voltage Vs is 5 V), and be applied as the first input voltage Via to the comparison circuit 215. At this time, the second input voltage Vib of the comparison circuit 215 has a voltage value corresponding to half of the voltage Vs (2.5 V when the voltage Vs is 5 V). Accordingly, the first input voltage Via which is applied to the negative input terminal has a value larger than the second input voltage Vib which is applied to the positive input terminal. As a result, the output voltage Vo of the comparison circuit 215 may become a low level (for example, 0 V).

The battery monitoring circuit 220 may receive a signal corresponding to the output voltage Vo of the electrolyte solution leakage detection sensor 210 through the input terminal IN (for example, an input pin). In the exemplary embodiment, the input terminal IN may be one of various input terminals which are provided to be used for the battery monitoring circuit 220 to receive monitoring results. In the exemplary embodiment, the electrolyte solution leakage detection device 200 may further include an analog-to-digital converter (ADC) 240 for converting the output voltage Vo of the electrolyte solution leakage detection sensor 210 into a digital signal which the battery monitoring circuit 220 can receive. In the exemplary embodiment, the electrolyte solution leakage detection device 200 may further include a diode D1 to block a current path in the opposite direction (i.e., a current path from the input terminal IN of the battery monitoring circuit 220 to the output terminal of the electrolyte solution leakage detection sensor 210). The anode of the diode D1 may be connected to the output terminal of the electrolyte solution leakage detection sensor 210, and the cathode thereof may be connected to the input terminal IN of the battery monitoring circuit 220.

The battery monitoring circuit 220 may be operated by a predetermined voltage V_BMIC which is applied to a power terminal Vcc (for example, a power pin). In the exemplary embodiment, the predetermined voltage V_BMIC may be the same voltage as the predetermined voltage Vs of the electrolyte solution leakage detection sensor 210. Also, the battery monitoring circuit 220 may perform communication with a battery management system (for example, reference symbol "10" in FIG. 1) through a transmission terminal Tx (for example, a transmission pin) and a reception terminal Rx (for example, a reception pin). The battery monitoring circuit 220 may transmit monitored data to the battery management system 10 through a communication line for transmission connected between the transmission terminal Tx and the battery management system 10, and receive a control signal from the battery management system 10 through a communication line for reception connected between the reception terminal Rx and the battery management system 10. In the exemplary embodiment, communication between the battery monitoring circuit 220 and the battery management system 10 may be universal asynchronous receiver/transmitter (UART) communication.

The battery monitoring circuit 220 may transmit information corresponding to the output voltage Vo of the electrolyte solution leakage detection sensor 210 received through the input terminal IN to, for example, the battery management system 10. As described above, when the electrolyte solution does not leak, the output voltage Vo of the electrolyte solution leakage detection sensor 210 is the low-level voltage (for example, 0 V). Accordingly, when the output voltage Vo of the electrolyte solution leakage detection sensor 210 is a voltage lower than a reference voltage, a processor of the external device (for example, the vehicle) or the battery management system 10 may determine that the electrolyte solution has not leaked.

In contrast, when the electrolyte solution leaks, the output voltage Vo of the electrolyte solution leakage detection sensor 210 is the high-level voltage (for example, 5 V). Accordingly, when the output voltage Vo of the electrolyte solution leakage detection sensor 210 is higher than the reference voltage, the processor of the external device or the battery management system 10 may determine that the electrolyte solution has leaked. As described above, the battery management system 10 or the external device may detect leakage of the electrolyte solution in the battery pack through the output signal of the battery monitoring circuit 220, and perform a protection operation. In the exemplary embodiment, when the output voltage Vo is lower than the reference voltage, the battery management system 10 may transmit a warning signal to the external device (for example, the vehicle). Accordingly, the driver of the vehicle may have the battery pack checked.

According to the present exemplary embodiment, since the resistor 211 is disposed between the power source and the ground terminal, it is possible to prevent the electrolyte solution detection unit 212 and the power source from being directly connected, thereby preventing a short circuit between the voltage Vs and the ground terminal, and it is possible to protect the battery module 110, the electrolyte solution leakage detection sensor 210, and the battery monitoring circuit 220 by limiting current. Also, since the electrolyte solution detection unit 212 is designed so as to be regarded as an open circuit when there is no leakage of the electrolyte solution, it is possible to prevent leakage current from occurring. Further, since the RC filter circuits 213 and 214 are adopted such that whether the electrolyte solution has leaked is prevented from being erroneously detected due to transient AC noise. Accordingly, the detection accuracy can be improved.

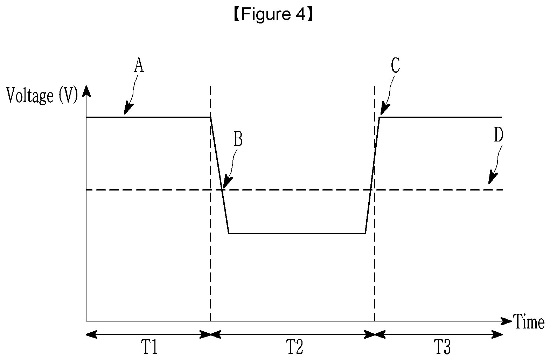

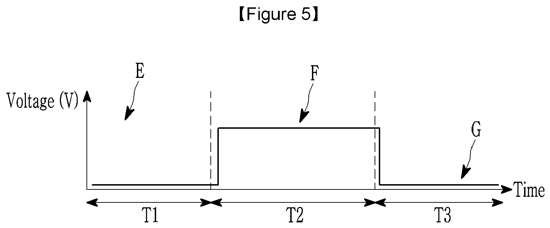

FIGS. 4 and 5 are drawings illustrating the operation of the electrolyte solution leakage detection device according to the exemplary embodiment.

Referring to FIGS. 4 and 5, a time period T1 may correspond to a normal state in which solution leakage has not occurred. In the time period T1, the first input voltage Via which is applied to the negative input terminal of the comparison circuit 215 may be 5 V (see reference symbol "A"). At this time, the output voltage Vo which is output from the output terminal of the comparison circuit 215 may be 0 V (see reference symbol "E"). Here, the second input voltage Vib which is applied to the positive input terminal of the comparison circuit 215 may be 2.5 V (see reference symbol "D").

A time period T2 may correspond to a state in which solution leakage has occurred. As solution leakage occurs, the first input voltage Via which is applied to the negative input terminal of the comparison circuit 215 decreases to 2.5 V (see reference symbol "B"). Subsequently, the first input voltage Via may further decrease to a voltage lower than 2.5 V as the resistance value of the electrolyte solution decreases as described above. Accordingly, the output voltage Vo which is output from the output terminal of the comparison circuit 215 may be 5 V (see reference symbol "F").

A time period T3 may correspond to a normal state after the leaked solution has been removed. In the time period T3, the first input voltage Via which is applied to the negative input terminal of the comparison circuit 215 may be 5 V (see reference symbol "C"). At this time, the output voltage Vo which is output from the output terminal of the comparison circuit 215 may be 0 V (see reference symbol "G").

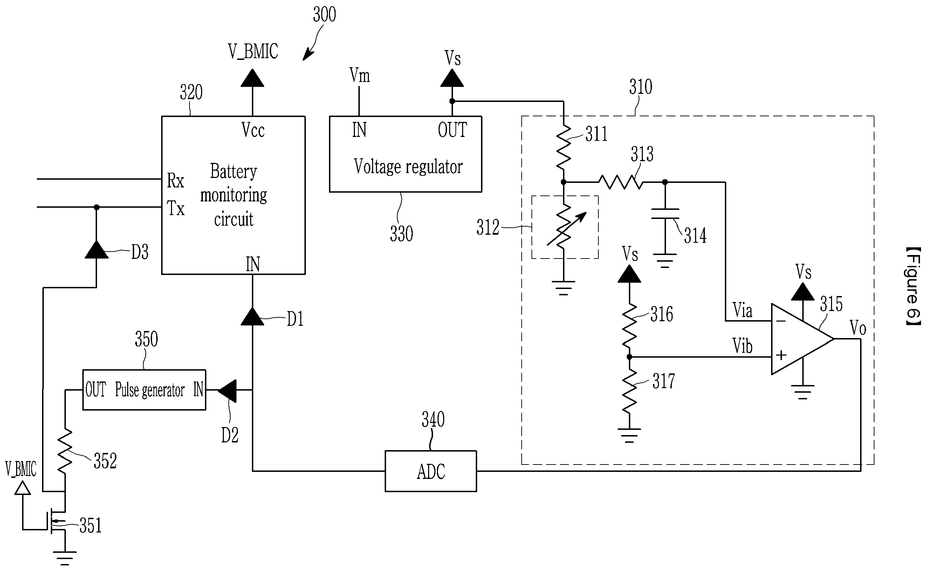

FIG. 6 is a drawing illustrating an electrolyte solution leakage detection device according to an exemplary embodiment.

Referring to FIG. 6, an electrolyte solution leakage detection device 300 includes an electrolyte solution leakage detection sensor 310 and a battery monitoring circuit 320. In the exemplary embodiment, the electrolyte solution leakage detection device 300 may correspond to the electrolyte solution leakage detection circuit 120 of FIG. 1.

The electrolyte solution leakage detection sensor 310 may include a resistor 311 and an electrolyte solution detection unit 312 which are connected in series between the power source for supplying the predetermined voltage Vs and a ground terminal, and the voltage of the contact point of the resistor 311 and the electrolyte solution detection unit 312 may be transmitted as a detection voltage to RC filter circuits 313 and 314. A detection voltage may pass through the RC filter circuits 313 and 314 and then be input as a first input voltage Via to a comparison circuit 315. Meanwhile, the electrolyte solution leakage detection sensor 310 may further include a plurality of resistors 316 and 317 which are connected in series between the power source for supplying the predetermined voltage Vs and the ground terminal. The voltage of the contact point of the plurality of resistors 316 and 317 may be input as a second input voltage Vib to the comparison circuit 315. In the exemplary embodiment, the electrolyte solution leakage detection device 300 may further include a voltage regulator 330 for generating a predetermined voltage Vs.

The battery monitoring circuit 320 receives a signal corresponding to an output voltage Vo of the electrolyte solution leakage detection sensor 310. In the exemplary embodiment, the electrolyte solution leakage detection device 300 may further include an ADC 340 for converting the output voltage Vo of the electrolyte solution leakage detection sensor 310 into a digital signal which the battery monitoring circuit 330 can receive. In the exemplary embodiment, the electrolyte solution leakage detection device 300 may further include a diode D1 to block a current path in the opposite direction.

In the exemplary embodiment, the battery monitoring circuit 320 may be set to one mode of an active mode in which it monitors a battery module (for example, reference symbol "110" in FIG. 1) and a shutdown mode in which it does not monitor the battery module 110. In the active mode, a predetermined voltage V_BMIC is supplied to a power terminal Vcc (for example, a power pin) of the battery monitoring circuit 320 to enable the battery monitoring circuit 320 to operate. In the shutdown mode, the predetermined voltage V_BMIC may be blocked so as not to be supplied to the power terminal Vcc of the battery monitoring circuit 320. Accordingly, the battery monitoring circuit 320 may not operate. In the exemplary embodiment, the predetermined voltage V_BMIC may be the same as the predetermined voltage Vs which is supplied to the electrolyte solution leakage detection sensor 310. In the exemplary embodiment, the electrolyte solution leakage detection device 300 includes a pulse generator 350 such that it is possible to detect electrolyte solution leakage even when the battery monitoring circuit 320 is in the shutdown mode.

An output voltage Vo of the electrolyte solution leakage detection sensor 310 may be supplied to an input terminal IN of the pulse generator 350. In the exemplary embodiment, a signal obtained by converting the output voltage Vo of the electrolyte solution leakage detection sensor 310 by the ADC 340 may be input to the input terminal IN of the pulse generator 350. In the exemplary embodiment, the electrolyte solution leakage detection device 300 may further include a diode D2 to block a current path in the opposite direction (i.e., a current path from the input terminal IN of the pulse generator 350 to the electrolyte solution leakage detection sensor 310). The anode of the diode D2 may be connected to the output terminal of the electrolyte solution leakage detection sensor 310, and the cathode thereof may be connected to the input terminal IN of the pulse generator 350.

Between the output terminal OUT of the pulse generator 350 and a ground terminal, a transistor 351 may be connected. In other words, a first terminal of the transistor 351 may be connected to the output terminal OUT of the pulse generator 350, and a second terminal of the transistor 351 may be connected to the ground terminal. Also, a control terminal of the transistor 351 receives the same voltage as that of the power terminal Vcc of the battery monitoring circuit 320. For example, the control terminal of the transistor 351 may be connected to the power terminal Vcc of the battery monitoring circuit 320. Further, the first terminal of the transistor 351 may be connected to a transmission terminal Tx (for example, a transmission pin) of the battery monitoring circuit 320. In the exemplary embodiment, the first terminal of the transistor 351 may be connected to a communication line for transmission between the transmission terminal Tx of the battery monitoring circuit 320 and a battery management system (for example, reference symbol "10" in FIG. 1). In the exemplary embodiment, the electrolyte solution leakage detection device 300 may further include a diode D3 to block a current path in the opposite direction (i.e., a current path from the communication line for transmission to the first terminal of the transistor 351). The anode of the diode D3 may be connected to the first terminal of the transistor 351, and the cathode thereof may be connected to the reception terminal Rx of the battery monitoring circuit 320. In the exemplary embodiment, between the output terminal OUT of the pulse generator 350 and the first terminal of the transistor 351, a resistor 352 may be connected.

The transistor 351 may be turned on when a predetermined voltage (for example, 5 V) is applied to the power terminal Vcc of the battery monitoring circuit 320, and may be turned off when the voltage is blocked so as not to be applied to the power terminal Vcc of the battery monitoring circuit 320. In the exemplary embodiment, the transistor 351 may be an n-channel transistor, for example, an n-channel metal oxide semiconductor field effect transistor (MOSFET). In this case, the first terminal, second terminal, and control terminal of the transistor 351 may be a drain, a source, and a gate, respectively.

In the active mode, the electrolyte solution leakage detection sensor 310 and the battery monitoring circuit 320 operate identically to the electrolyte solution leakage detection sensor 210 and the battery monitoring circuit 220 described with reference to FIG. 2, and thus a description thereof will not be made. Meanwhile, in the active mode, since the predetermined voltage is applied to the power terminal Vcc of the battery monitoring circuit 320, the transistor 351 is turned on. Accordingly, 0 V is applied to the anode of the diode D3, which may not affect communication through the transmission terminal Tx of the battery monitoring circuit 320.

In the shutdown mode, the voltage is blocked so as not to be applied to the power terminal Vcc of the battery monitoring circuit 320, such that the transistor 351 is turned off. Also, when the electrolyte solution leaks, since the output voltage Vo is output from the electrolyte solution leakage detection sensor 310, the pulse generator 350 may generate a pulse signal and output it to the output terminal OUT, in response to the output voltage Vo of the electrolyte solution leakage detection sensor 310. In other words, when the voltage input to the input terminal IN of the pulse generator 350 is higher than a threshold voltage, the pulse generator may generate a pulse signal and output it to the output terminal OUT. In this case, since the transistor 351 is off, the pulse signal of the pulse generator 350 may be applied to the transmission terminal Tx of the battery monitoring circuit 320. The battery monitoring circuit 320 may transition to the active mode in response to the pulse signal transmitted to the transmission terminal Tx. Then, the battery monitoring circuit 320 may transmit information corresponding to the output voltage Vo of the electrolyte solution leakage detection sensor 310 to the battery management system 10.

In the exemplary embodiment, the transistor 351, the resistor 352, and the diode D3 transmit the pulse signal of the pulse generator 350 to the transmission terminal Tx of the battery monitoring circuit 320 in the shutdown mode, and operate as a transfer circuit which blocks transfer of the pulse signal, in the active mode.

According to the above-described exemplary embodiment, the battery monitoring circuit 320 may detect electrolyte solution leakage even in the shutdown mode.

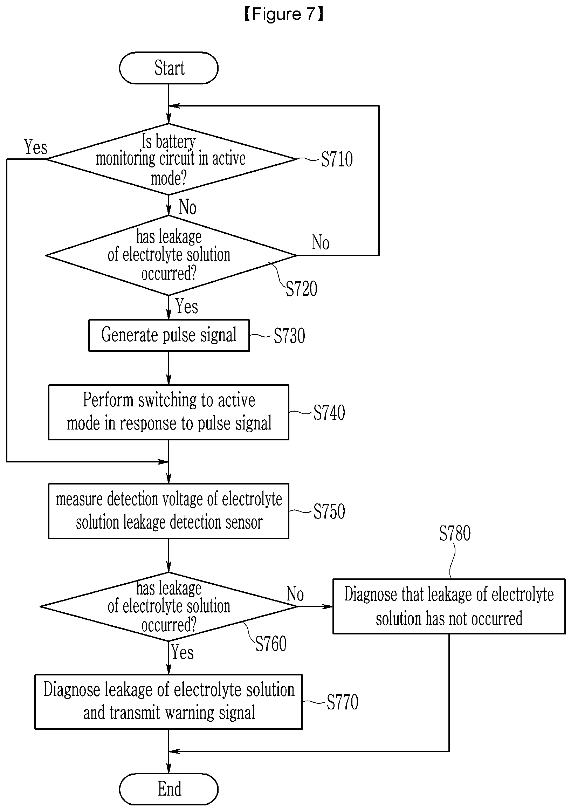

FIG. 7 is a flow chart illustrating an electrolyte solution leakage detection method of the battery device according to the exemplary embodiment.

Referring to FIG. 7, when a battery monitoring circuit for a battery pack is in an active mode (S710), the battery monitoring circuit measures a voltage corresponding to electrolyte solution leakage (S750). In the exemplary embodiment, the battery monitoring circuit may measure a detection voltage which is output from an electrolyte solution leakage detection sensor (S750).

When the battery monitoring circuit for the battery pack is in a shutdown mode, if leakage of the electrolyte solution occurs in the battery pack (S720), the battery device generates a pulse signal in response to the leakage of the electrolyte solution (S730). In response to the pulse signal, the battery monitoring circuit transitions to the active mode (S740), and measures the voltage corresponding to the leakage of the electrolyte solution (S750). In the exemplary embodiment, in response to an output voltage of a comparison circuit output from the electrolyte solution leakage detection sensor in response to the leakage of the electrolyte solution, a pulse generator may generate a pulse signal, and the battery monitoring circuit may transition to the active mode in response to the pulse signal of the pulse generator.

When the voltage measured by the battery monitoring circuit is higher than a reference voltage (S760), the battery device may diagnose the leakage of the electrolyte solution, and transmit a warning signal to an external device (for example, a vehicle) (S770). When the measured voltage is not higher than the reference voltage, the battery device may diagnose that leakage of the electrolyte solution has not occurred (S780).

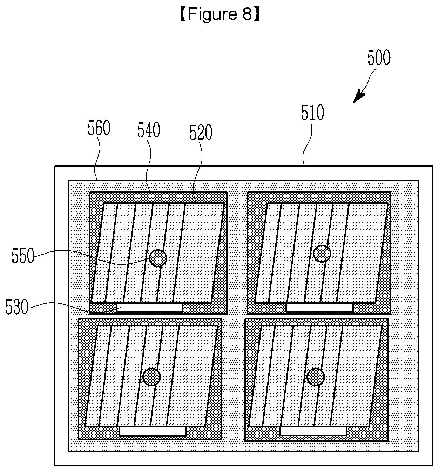

Now, a battery pack to which electrolyte solution leakage detection methods according to various exemplary embodiments may be applied will be described with reference to FIG. 8.

FIG. 8 is a drawing illustrating an example of the structure of a battery pack according to an exemplary embodiment.

Referring to FIG. 8, a battery pack 500 may be formed by combining a lower case 510 and an upper case (not shown in the drawing), and includes battery modules 520 provided therein. In FIG. 8, it is shown for ease of explanation that the battery pack 500 includes four battery modules 520; however, the number of battery modules 520 is not limited thereto. The battery modules 520 are connected to battery monitoring circuits 530, respectively. Each battery monitoring circuit 530 may monitor the battery cell voltages, temperature, and the like of a corresponding battery module 520.

Below each battery module 520, a lower cover 540 may be formed. Each lower cover 540 may have a shape capable of collecting an electrolyte solution which leaks in a corresponding battery module 520. To each lower cover 540, an electrolyte solution leakage detection sensor 550 may be attached. Each electrolyte solution leakage detection sensor 550 may sense the electrolyte solution collected in the lower cover 540, and output a corresponding voltage.

In the exemplary embodiment, on the lower case 510, a battery pack inner cover 560 may be formed. The battery pack inner cover 560 may be formed between the lower case 510 and the lower covers 540. The battery pack inner cover 560 may be formed of a non-conductive material to block a current path to the lower case 510 which may be formed by the leaked electrolyte solution.

While this invention has been described in connection with what is presently considered to be practical exemplary embodiments, it is to be understood that the invention is not limited to the disclosed embodiments. On the contrary, it is intended to cover various modifications and equivalent arrangements included within the scope of the appended claims.

## Claims

1. A battery pack (100; 500) comprising:
a battery module (110; 520) that includes a plurality of battery cells;
a battery monitoring circuit (122; 220) that is connected to the battery module (110) and monitors the battery module (100); and
an electrolyte solution leakage detection sensor (121; 210) that detects an electrolyte solution which leaks in the battery module (110),
wherein the electrolyte solution leakage detection sensor (121; 210; 550) includes the following:
an electrolyte solution detection unit (212) whose resistance value varies in response to the electrolyte solution which leaks in the battery module (110); and
a comparison circuit (215) is configured to determine on the basis of the resistance value of the electrolyte solution detection unit (212) and to transmit an output voltage (Vo) to an input terminal of the battery monitoring circuit (122; 220);
the battery monitoring circuit (122, 220) monitors the battery module in an active mode;
the battery pack further comprising:
a pulse generator (350) that generates a pulse signal for switching the battery monitoring circuit (122; 220) to the active mode and outputs the pulse signal to an output terminal, when the output voltage (Vo) is higher than a threshold voltage; and
a transfer circuit that transfers the pulse signal to a transmission terminal of the battery monitoring circuit (122; 220) in a shutdown mode of the battery monitoring circuit (122; 220), and blocks transfer of the pulse signal to the transmission terminal of the battery monitoring circuit (122; 220) in the active mode.

2. The battery pack of claim 1, wherein:
the electrolyte solution leakage detection sensor (121; 210) further includes
a first resistor (211) that is connected in series with the electrolyte solution detection unit (212) between a power source for supplying a first voltage (Vs) and a ground terminal; and
a second resistor (216) and a third resistor (217) that are connected in series between the power source and the ground terminal,
wherein the comparison circuit (215) that receives a detection voltage of the contact point of the first resistor (211) and the electrolyte solution detection unit (212) as a first input voltage (Via), and receives a voltage of the contact point of the second resistor (216) and the third resistor (217) as a second input voltage (Vib), and transmits an output voltage (Vo) to an input terminal of the battery monitoring circuit (122; 220).

3. The battery pack of claim 2, wherein:
the output voltage (Vo) is a high-level voltage when the first input voltage (Via) is smaller than the second input voltage (Vib), and is a low-level voltage when the first input voltage (Via) is larger than the second input voltage (Vib).

4. The battery pack of claim 3, wherein:
when the output voltage (Vo) is higher than a reference voltage, electrolyte solution leakage in the battery module is diagnosed.

5. The battery pack of claim 2, wherein:
the electrolyte solution detection unit (212) includes a first detection node (N1) and a second detection node (N2), and when the first detection node (N1) and the second detection node (N2) are electrically connected, electrolyte solution leakage in the battery module is diagnosed.

6. The battery pack of claim 2, further comprising:
an RC filter circuit (213, 214) that receives the detection voltage of the contact point of the first resistor (211) and the electrolyte solution detection unit (212) and transfers the detection voltage to the comparison circuit (215).

7. The battery pack of claim 2, further comprising:
a voltage regulator (230) that generates the first voltage from a voltage (Vn) of the battery module (110).

8. The battery pack of claim 1, further comprising:
a lower case (510) of the battery pack (500); and
a lower cover (540) that is formed on the lower case (510), is formed below the battery module, collects the electrolyte solution which leaks in the battery module (520), and has the electrolyte solution leakage detection sensor (550) attached thereto.

9. A battery device comprising:
a battery pack (100; 500) according to any one of claims 1 to 8; and
a battery management system (10) that manages the battery monitoring circuit and diagnoses leakage of the electrolyte solution by receiving information from the battery monitoring circuit.

10. An electrolyte solution leakage detection method of a battery device which includes a battery module (110; 520), a battery monitoring circuit (122; 220) for monitoring the battery module (110; 520), and an electrolyte solution leakage detection sensor (121; 210; 550), the method comprising:
a step of generating a pulse signal (S730) when an electrolyte solution leaks in the battery module (110; 520) in a state where the battery monitoring circuit (122; 220) is in a shutdown mode;
a step of switching (S740) the battery monitoring circuit (122; 220) to an active mode in response to the pulse signal;
a step of allowing (S750) the electrolyte solution leakage detection sensor (121; 210; 550 to measure an output voltage (Vo) of a comparator circuit (215) of the electrolyte solution leakage detection sensor (121; 210; 550), on the basis of a resistance value which varies in response to the electrolyte solution leaking; and
a step of allowing the battery monitoring circuit (122; 220), which is in the active mode, to diagnose leakage of the electrolyte solution, when the output voltage is higher than a reference voltage;
the method further comprising:
transferring the pulse signal to a transmission terminal of the battery monitoring circuit (122; 220) in a shutdown mode of the battery monitoring circuit (122; 220) and blocking transfer of the pulse signal to the transmission terminal of the battery monitoring circuit (122; 220) in the active mode.

11. The electrolyte solution leakage detection method of claim 10, wherein:
the step of measuring the output voltage includes the following:
a step of receiving a detection voltage of the contact point of a first resistor (211) and the electrolyte solution detection unit (212) as a first input voltage;
a step of receiving a voltage of the contact point of a second resistor (216) and a third resistor (217) as a second input voltage; and
a step of comparing the first input voltage (Via) and the second input voltage (Vib), outputting a high-level voltage when the first input voltage (Via) is smaller than the second input voltage (Vib), and outputting a low-level voltage when the first input voltage (Via) is larger than the second input voltage (Vib).

## Patentansprüche

1. Batteriepack (100; 500), umfassend:
• ein Batteriemodul (110; 520), das eine Vielzahl von Batteriezellen enthält;
• eine Batterieüberwachungsschaltung (122; 220), die mit dem Batteriemodul (110) verbunden ist und das Batteriemodul (100) überwacht; und
• einen Elektrolytlösungs-Leckagedetektionssensor (121; 210), der eine Elektrolytlösung detektiert, die in dem Batteriemodul (110) austritt,
wobei der Elektrolytlösungs-Leckagedetektionssensor (121; 210; 550) Folgendes enthält:
• eine Elektrolytlösungs-Detektionseinheit (212), deren Widerstandswert in Reaktion auf die Elektrolytlösung variiert, die in dem Batteriemodul (110) austritt; und
• eine Vergleichsschaltung (215), die eingerichtet ist, um auf der Basis des Widerstandswerts der Elektrolytlösungs-Detektionseinheit (212) zu bestimmen und eine Ausgangsspannung (Vₒ) an einen Eingangsanschluss der Batterieüberwachungsschaltung (122; 220) zu übertragen;
die Batterieüberwachungsschaltung (122; 220) das Batteriemodul in einem aktiven Modus überwacht;
das Batteriepack ferner umfassend:
• einen Impulsgenerator (350), der ein Impulssignal zum Umschalten der Batterieüberwachungsschaltung (122; 220) in den aktiven Modus erzeugt und das Impulssignal an einen Ausgangsanschluss ausgibt, wenn die Ausgangsspannung (Vₒ) höher ist als eine Schwellenspannung; und
• eine Übertragungsschaltung, die das Impulssignal an einen Übertragungsanschluss der Batterieüberwachungsschaltung (122; 220) in einem Abschaltmodus der Batterieüberwachungsschaltung (122; 220) überträgt und die Übertragung des Impulssignals an den Übertragungsanschluss der Batterieüberwachungsschaltung (122; 220) in dem aktiven Modus blockiert.

2. Batteriepack nach Anspruch 1, wobei:
der Elektrolytlösungs-Leckagedetektionssensor (121; 210) ferner Folgendes enthält:
• einen ersten Widerstand (211), der mit der Elektrolytlösungs-Detektionseinheit (212) zwischen einer Stromquelle zum Liefern einer ersten Spannung (Vₛ) und einem Masseanschluss in Reihe geschaltet ist; und
• einen zweiten Widerstand (216) und einen dritten Widerstand (217), die zwischen der Stromquelle und dem Masseanschluss in Reihe geschaltet sind,
wobei die Vergleichsschaltung (215) eine Detektionsspannung des Kontaktpunkts des ersten Widerstands (211) und der Elektrolytlösungs-Detektionseinheit (212) als eine erste Eingangsspannung (Vᵢₐ) empfängt, und eine Spannung des Kontaktpunkts des zweiten Widerstands (216) und des dritten Widerstands (217) als eine zweite Eingangsspannung (V_{ib}) empfängt, und eine Ausgangsspannung (Vₒ) an einen Eingangsanschluss der Batterieüberwachungsschaltung (122; 220) überträgt.

3. Batteriepack nach Anspruch 2, wobei:
die Ausgangsspannung (Vₒ) eine High-Pegel-Spannung ist, wenn die erste Eingangsspannung (Vᵢₐ) kleiner ist als die zweite Eingangsspannung (V_{ib}), und eine Low-Pegel-Spannung ist, wenn die erste Eingangsspannung (Vᵢₐ) größer ist als die zweite Eingangsspannung (V_{ib}).

4. Batteriepack nach Anspruch 3, wobei:
wenn die Ausgangsspannung (Vₒ) höher ist als eine Referenzspannung, eine Elektrolytlösungsleckage in dem Batteriemodul diagnostiziert wird.

5. Batteriepack nach Anspruch 2, wobei:
die Elektrolytlösungs-Detektionseinheit (212) einen ersten Detektionsknoten (N₁) und einen zweiten Detektionsknoten (N₂) enthält, und wenn der erste Detektionsknoten (N₁) und der zweite Detektionsknoten (N₂) elektrisch verbunden sind, eine Elektrolytlösungsleckage in dem Batteriemodul diagnostiziert wird.

6. Batteriepack nach Anspruch 2, ferner umfassend:
eine RC-Filterschaltung (213, 214), die die Detektionsspannung des Kontaktpunkts des ersten Widerstands (211) und der Elektrolytlösungs-Detektionseinheit (212) empfängt und die Detektionsspannung an die Vergleichsschaltung (215) überträgt.

7. Batteriepack nach Anspruch 2, ferner umfassend:
einen Spannungsregler (230), der die erste Spannung aus einer Spannung (Vₙ) des Batteriemoduls (110) erzeugt.

8. Batteriepack nach Anspruch 1, ferner umfassend:
• ein Untergehäuse (510) des Batteriepacks (500); und
• eine untere Abdeckung (540), die an dem Untergehäuse (510) ausgebildet ist, unterhalb des Batteriemoduls ausgebildet ist, die Elektrolytlösung auffängt, die in dem Batteriemodul (520) austritt, und an der der Elektrolytlösungs-Leckagedetektionssensor (550) angebracht ist.

9. Batterievorrichtung, umfassend:
• ein Batteriepack (100; 500) nach einem der Ansprüche 1 bis 8; und
• ein Batteriemanagementsystem (10), das die Batterieüberwachungsschaltung verwaltet und eine Leckage der Elektrolytlösung durch Empfangen von Informationen von der Batterieüberwachungsschaltung diagnostiziert.

10. Verfahren zur Detektion einer Elektrolytlösungsleckage einer Batterievorrichtung, die ein Batteriemodul (110; 520), eine Batterieüberwachungsschaltung (122; 220) zum Überwachen des Batteriemoduls (110; 520) und einen Elektrolytlösungs-Leckagedetektionssensor (121; 210; 550) enthält, das Verfahren umfassend:
• einen Schritt des Erzeugens eines Impulssignals (S730), wenn eine Elektrolytlösung in dem Batteriemodul (110; 520) in einem Zustand austritt, in dem sich die Batterieüberwachungsschaltung (122; 220) in einem Abschaltmodus befindet;
• einen Schritt des Umschaltens (S740) der Batterieüberwachungsschaltung (122; 220) in einen aktiven Modus in Reaktion auf das Impulssignal;
• einen Schritt des Ermöglichens (S750), dass der Elektrolytlösungs-Leckagedetektionssensor (121; 210; 550) eine Ausgangsspannung (Vₒ) einer Komparatorschaltung (215) des Elektrolytlösungs-Leckagedetektionssensors (121; 210; 550) auf der Basis eines Widerstandswerts misst, der in Reaktion auf das Austreten der Elektrolytlösung variiert; und
• einen Schritt des Ermöglichens, dass die Batterieüberwachungsschaltung (122; 220), die sich in dem aktiven Modus befindet, eine Leckage der Elektrolytlösung diagnostiziert, wenn die Ausgangsspannung höher ist als eine Referenzspannung;
das Verfahren ferner umfassend:
Übertragen des Impulssignals an einen Übertragungsanschluss der Batterieüberwachungsschaltung (122; 220) in einem Abschaltmodus der Batterieüberwachungsschaltung (122; 220) und Blockieren der Übertragung des Impulssignals an den Übertragungsanschluss der Batterieüberwachungsschaltung (122; 220) in dem aktiven Modus.

11. Verfahren zur Detektion einer Elektrolytlösungsleckage nach Anspruch 10, wobei:
der Schritt des Messens der Ausgangsspannung Folgendes enthält:
• einen Schritt des Empfangens einer Detektionsspannung des Kontaktpunkts eines ersten Widerstands (211) und der Elektrolytlösungs-Detektionseinheit (212) als eine erste Eingangsspannung;
• einen Schritt des Empfangens einer Spannung des Kontaktpunkts eines zweiten Widerstands (216) und eines dritten Widerstands (217) als eine zweite Eingangsspannung; und
• einen Schritt des Vergleichens der ersten Eingangsspannung (Vᵢₐ) und der zweiten Eingangsspannung (V_{ib}), des Ausgebens einer High-Pegel-Spannung, wenn die erste Eingangsspannung (Vᵢₐ) kleiner ist als die zweite Eingangsspannung (V_{ib}), und des Ausgebens einer Low-Pegel-Spannung, wenn die erste Eingangsspannung (Vᵢₐ) größer ist als die zweite Eingangsspannung (V_{ib}).

## Revendications

1. Un bloc-batterie (100 ; 500) comprenant :
un module de batterie (110 ; 520) qui comporte une pluralité de cellules de batterie ;
un circuit de surveillance de batterie (122 ; 220) qui est connecté au module de batterie (110) et surveille le module de batterie (100) ; et
un capteur de détection de fuite de solution d'électrolyte (121 ; 210) qui détecte une solution d'électrolyte qui fuit dans le module de batterie (110),
dans lequel le capteur de détection de fuite de solution d'électrolyte (121 ; 210 ; 550) comporte ce qui suit :
une unité de détection de solution d'électrolyte (212) dont la valeur de résistance varie en réponse à la solution d'électrolyte qui fuit dans le module de batterie (110) ; et
un circuit de comparaison (215) est configuré pour déterminer sur la base de la valeur de résistance de l'unité de détection de solution d'électrolyte (212) et pour transmettre une tension de sortie (Vₒ) à une borne d'entrée du circuit de surveillance de batterie (122 ; 220) ;
le circuit de surveillance de batterie (122 ; 220) surveille le module de batterie dans un mode actif ;
le bloc-batterie comprenant en outre :
un générateur d'impulsions (350) qui génère un signal impulsionnel pour commuter le circuit de surveillance de batterie (122 ; 220) vers le mode actif et délivre le signal impulsionnel à une borne de sortie, lorsque la tension de sortie (Vₒ) est supérieure à une tension de seuil ; et
un circuit de transfert qui transfère le signal impulsionnel à une borne de transmission du circuit de surveillance de batterie (122 ; 220) dans un mode d'arrêt du circuit de surveillance de batterie (122 ; 220), et bloque le transfert du signal impulsionnel vers la borne de transmission du circuit de surveillance de batterie (122 ; 220) dans le mode actif.

2. Le bloc-batterie selon la revendication 1, dans lequel :
le capteur de détection de fuite de solution d'électrolyte (121 ; 210) comporte en outre :
une première résistance (211) qui est connectée en série avec l'unité de détection de solution d'électrolyte (212) entre une source d'alimentation pour fournir une première tension (Vₛ) et une borne de masse ; et
une deuxième résistance (216) et une troisième résistance (217) qui sont connectées en série entre la source d'alimentation et la borne de masse,
dans lequel le circuit de comparaison (215) reçoit une tension de détection du point de contact de la première résistance (211) et de l'unité de détection de solution d'électrolyte (212) en tant que première tension d'entrée (Vᵢₐ), et reçoit une tension du point de contact de la deuxième résistance (216) et de la troisième résistance (217) en tant que seconde tension d'entrée (V_{ib}), et transmet une tension de sortie (Vₒ) à une borne d'entrée du circuit de surveillance de batterie (122 ; 220).

3. Le bloc-batterie selon la revendication 2, dans lequel :
la tension de sortie (Vₒ) est une tension de haut niveau lorsque la première tension d'entrée (Vᵢₐ) est inférieure à la seconde tension d'entrée (V_{ib}), et est une tension de bas niveau lorsque la première tension d'entrée (Vᵢₐ) est supérieure à la seconde tension d'entrée (V_{ib}).

4. Le bloc-batterie selon la revendication 3, dans lequel :
lorsque la tension de sortie (Vₒ) est supérieure à une tension de référence, une fuite de solution d'électrolyte dans le module de batterie est diagnostiquée.

5. Le bloc-batterie selon la revendication 2, dans lequel :
l'unité de détection de solution d'électrolyte (212) comporte un premier nœud de détection (N₁) et un second nœud de détection (N₂), et lorsque le premier nœud de détection (N₁) et le second nœud de détection (N₂) sont connectés électriquement, une fuite de solution d'électrolyte dans le module de batterie est diagnostiquée.

6. Le bloc-batterie selon la revendication 2, comprenant en outre :
un circuit de filtre RC (213, 214) qui reçoit la tension de détection du point de contact de la première résistance (211) et de l'unité de détection de solution d'électrolyte (212) et transfère la tension de détection au circuit de comparaison (215).

7. Le bloc-batterie selon la revendication 2, comprenant en outre :
un régulateur de tension (230) qui génère la première tension à partir d'une tension (Vₙ) du module de batterie (110).

8. Le bloc-batterie selon la revendication 1, comprenant en outre :
un boîtier inférieur (510) du bloc-batterie (500) ; et
un couvercle inférieur (540) qui est formé sur le carter inférieur (510), est formé sous le module de batterie, collecte la solution d'électrolyte qui fuit dans le module de batterie (520), et auquel est fixé le capteur de détection de fuite de solution d'électrolyte (550).

9. Un dispositif de batterie comprenant :
un bloc-batterie (100 ; 500) selon l'une quelconque des revendications 1 à 8 ; et
un système de gestion de batterie (10) qui gère le circuit de surveillance de batterie et diagnostique une fuite de la solution d'électrolyte en recevant des informations en provenance du circuit de surveillance de batterie.

10. Un procédé de détection de fuite de solution d'électrolyte d'un dispositif de batterie qui comporte un module de batterie (110 ; 520), un circuit de surveillance de batterie (122 ; 220) pour surveiller le module de batterie (110 ; 520), et un capteur de détection de fuite de solution d'électrolyte (121 ; 210 ; 550), le procédé comprenant :
une étape consistant à générer un signal impulsionnel (S730) lorsqu'une solution d'électrolyte fuit dans le module de batterie (110 ; 520) dans un état où le circuit de surveillance de batterie (122 ; 220) est dans un mode d'arrêt ;
une étape consistant à commuter (S740) le circuit de surveillance de batterie (122 ; 220) vers un mode actif en réponse au signal impulsionnel ;
une étape consistant à permettre (S750) au capteur de détection de fuite de solution d'électrolyte (121 ; 210 ; 550) de mesurer une tension de sortie (Vₒ) d'un circuit comparateur (215) du capteur de détection de fuite de solution d'électrolyte (121 ; 210 ; 550), sur la base d'une valeur de résistance qui varie en réponse à la fuite de solution d'électrolyte ; et
une étape consistant à permettre au circuit de surveillance de batterie (122 ; 220), qui est dans le mode actif, de diagnostiquer une fuite de la solution d'électrolyte, lorsque la tension de sortie est supérieure à une tension de référence ;
le procédé comprenant en outre :
le transfert du signal impulsionnel à une borne de transmission du circuit de surveillance de batterie (122 ; 220) dans un mode d'arrêt du circuit de surveillance de batterie (122 ; 220) et le blocage du transfert du signal impulsionnel vers la borne de transmission du circuit de surveillance de batterie (122 ; 220) dans le mode actif.

11. Le procédé de détection de fuite de solution d'électrolyte selon la revendication 10, dans lequel :
l'étape de mesure de la tension de sortie comporte ce qui suit :
une étape consistant à recevoir une tension de détection du point de contact d'une première résistance (211) et de l'unité de détection de solution d'électrolyte (212) en tant que première tension d'entrée ;
une étape consistant à recevoir une tension du point de contact d'une deuxième résistance (216) et d'une troisième résistance (217) en tant que seconde tension d'entrée ; et
une étape consistant à comparer la première tension d'entrée (Vᵢₐ) et la seconde tension d'entrée (V_{ib}), à délivrer une tension de haut niveau lorsque la première tension d'entrée (Vᵢₐ) est inférieure à la seconde tension d'entrée (V_{ib}), et à délivrer une tension de bas niveau lorsque la première tension d'entrée (Vᵢₐ) est supérieure à la seconde tension d'entrée (V_{ib}).
